# EUROPEAN PATENT APPLICATION

(11) **EP 2 237 650 A1**
(43) Date of publication of application: **06.10.2010**
(21) Application number: 08839429.1
(22) Date of filing: 08.10.2008
(51) Int. Cl.: H05K 1/14, H01B 1/22, H01R 11/01

(54) **CIRCUIT CONNECTING ADHESIVE FILM AND CIRCUIT CONNECTING STRUCTURE**

(30) Priority: 15.10.2007 JP 2007267809
(71) Applicant: Hitachi Chemical Company, Ltd., Tokyo 163-0449 (JP)
(72) Inventor: TATSUZAWA, Takashi, Chikusei-shi Ibaraki 308-8524 (JP); KOBAYASHI, Kouji, Chikusei-shi Ibaraki 308-8524 (JP); ITO, Akihiro, Chikusei-shi Ibaraki 308-8524 (JP); YOKOZUMI, Tomomi, Tokyo 108-0023 (JP)
(74) Representative: von Kreisler Selting Werner
(86) International application number: PCT/JP2008/068263
(87) International publication number: WO 2009/051043

(57) **Abstract**

A circuit connecting adhesive film comprising an insulating adhesive, conductive particles and a particulate non-conductive phase containing a polyamide-based elastomer and/or a polyester-based elastomer, wherein the conductive particles and non-conductive phase are dispersed in the insulating adhesive.

## Description

### Technical Field

The present invention relates to a circuit connecting adhesive film and a circuit connecting structure.

### Background Art

Circuit-connecting materials, used for heating and pressing of circuit boards with mutually opposing electrodes for electrical connection between electrodes in the pressing direction, include anisotropic conductive adhesive films comprising conductive particles dispersed in epoxy-based adhesives or acrylic adhesives, for example. Anisotropic conductive adhesive films are widely used for electrical connection between liquid crystal display (LCD) panels and TCP (Tape Carrier Package) or COF (Chip On Flex) members on which are mounted mainly semiconductor chips that drive the LCDs, and between TCPs or COFs and printed circuit boards.

Recently, flip-chip mounting; which is advantageous for thickness reduction and narrow-pitch connection, has come to be employed instead of wire bonding methods even when semiconductor chips are mounted face-down directly on LCD panels or printed circuit boards. Anisotropic conductive adhesive films are used as circuit-connecting materials in such cases as well (see Patent documents 1-4, for example).

With the employment of COFs and increasingly finer pitches of circuits in LCD modules in recent years, shorting between adjacent electrodes connected using circuit-connecting materials is becoming a more notable problem. One means that has been proposed as a technique for preventing electrical shorting is dispersion of insulating particles in the adhesive component (see Patent documents 5-9, for example).

Other techniques include adding silicone particles to the adhesive that is used for bonding to wiring members with boards composed of insulating organic materials or glass, or wiring members having surfaces at least partially formed of silicon nitride, silicone resin and/or polyimide resin (Patent document 10, for example), and dispersing rubber particles in the adhesive to lower internal stress caused by differences in the coefficient of thermal expansion after bonding (Patent document 11, for example).
[Patent document 1] JP 59-120436 A
[Patent document 2] JP 60-191228 A
[Patent document 3] JP 1-251787 A
[Patent document 4] JP 7-90237 A
[Patent document 5] JP 51-20941 A
[Patent document 6] JP 3-29207 A
[Patent document 7] JP 4-174980 A
[Patent document 8] JP 3048197 B2
[Patent document 9] JP 3477367 B2
[Patent document 10] WO 01/014484 A
[Patent document 11] JP 2001-323249 A

### Disclosure of the Invention

### Problems to be Solved by the Invention

When a circuit-connecting material is used to connect an LCD panel having an opaque metal electrode such as Al or Cr formed on a glass panel, such as in a TFT panel, the state of connection can be confirmed by pressing the conductive particles and observing the "impression" formed on the electrode surface. If an "impression" is satisfactorily formed by flattening of the conductive particles, then the circuit connection can be judged to have been properly formed. The "impression" is observed from the glass panel side under polarized light.

However, with conventional circuit-connecting materials employing insulating particles to prevent shorting, any impression formed by the insulating particles blends with that of the conductive particles, while the distribution of the impressions by the conductive particles themselves is also non-uniform, and therefore it has sometimes been difficult to properly confirm the state of connection.

Although the blending of impressions can be improved to some extent by using relatively soft insulating particles such as silicone fine particles, a large particle size can cause impressions even with soft insulating particles. In most cases it is extremely difficult to completely eliminate large-sized particles from among soft insulating particles. Moreover, while using low melting point insulating particles such as nylon results in minimal interference of the impressions by the conductive particles, it tends to create voids (air bubbles) around the insulating particles after connection.

The present invention has been accomplished in light of these circumstances, and its major object is to provide a circuit connecting adhesive film that allows satisfactory visibility of impressions on electrode surfaces by conductive particles while preventing shorting between adjacent circuits, and that can also prevent generation of voids after connection.

### Means for Solving the Problems

The circuit connecting adhesive film of the invention comprises an insulating adhesive, conductive particles and a particulate non-conductive phase containing a polyamide-based elastomer and/or a polyester-based elastomer. The conductive particles and non-conductive phase are dispersed in the insulating adhesive.

According to the circuit connecting adhesive film of the invention having the specific construction described above, it is possible to obtain satisfactory visibility of impressions on electrode surfaces by conductive particles while preventing shorting between adjacent circuits, and also to prevent generation of voids after connection.

The circuit connecting adhesive film of the invention preferably comprises the non-conductive phase at 1-60 parts by weight with respect to 100 parts by weight of the insulating adhesive. The melting point of the non-conductive phase is preferably 100-250°C. The non-conductive phase preferably dissolves in the insulating adhesive when the circuit connecting adhesive film has been heated and pressed. If the circuit-connecting material satisfies at least one of these conditions, the effect of the invention will be even more prominently exhibited.

According to another aspect, the invention relates to a circuit connecting structure comprising a first circuit member with a first connecting terminal, a second circuit member with a second connecting terminal that is laid facing and electrically connected to the first connecting terminal, and an adhesive layer situated between the first circuit member and second circuit member and bonding them. The adhesive layer in the circuit connecting structure of the invention is a layer that can be formed by heating and pressing the circuit connecting adhesive film of the invention that has been situated between the first circuit member and second circuit member.

According to the circuit connecting structure of the invention, shorting between adjacent circuits is prevented while visibility of impressions on electrode surfaces by conductive particles is satisfactory, and generation of voids after connection is also adequately inhibited.

### Effect of the Invention

According to the invention it is possible to obtain satisfactory visibility of impressions on electrode surfaces by conductive particles while preventing shorting between adjacent circuits, and also to prevent generation of voids after connection.

### Brief Description of the Drawings

Fig. 1 is an end view of an embodiment of a circuit connecting adhesive film.
Fig. 2 is an end view of an embodiment of a method for producing a circuit connecting structure.
Fig. 3 is a photomicrograph of the joint of the circuit connecting structure fabricated in Comparative Example 2.
Fig. 4 is a photomicrograph of the joint of the circuit connecting structure fabricated in Comparative Example 3.
Fig. 5 is a photomicrograph of the joint of the circuit connecting structure fabricated in Comparative Example 5.
Fig. 6 is a photomicrograph of the joint of the circuit connecting structure fabricated in Example 1.
Fig. 7 is a photomicrograph of the joint of the circuit connecting structure fabricated in Example 1.
Fig. 8 is a photomicrograph of the joint of the circuit connecting structure fabricated in Example 3.

### Brief Description of the Drawings

### Explanation of Symbols

1: Circuit connecting adhesive film (anisotropic conductive adhesive), 2: LCD panel, 5: COF, 10: insulating adhesive, 12: conductive particles, 14: non-conductive phase, 20: glass panel, 21: connecting terminal, 30: liquid crystal display, 50: resin board, 51: connecting terminal, 60: impression from non-conductive particles, 70: impression from conductive particles, 100: circuit connecting structure.

### Best Modes for Carrying Out the Invention

Preferred embodiments of the invention will now be explained in detail, with reference to the accompanying drawings as necessary. However, the present invention is not limited to the embodiments described below.

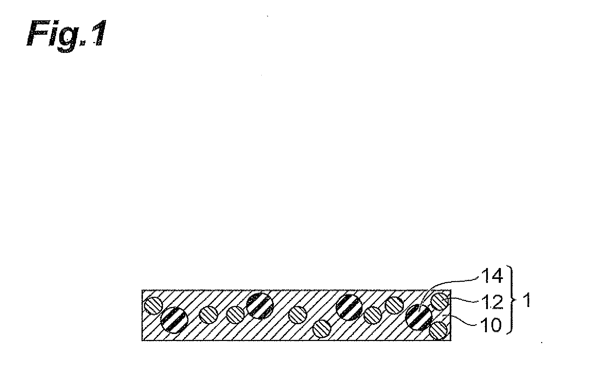

Fig. 1 is a cross-sectional view of an embodiment of a circuit connecting adhesive film. The circuit connecting adhesive film 1 shown in Fig. 1 comprises a film-like insulating adhesive 10, conductive particles 12 and a particulate non-conductive phase 14 containing a polyamide-based elastomer and/or a polyester-based elastomer. The conductive particles 12 and non-conductive phase 14 are dispersed in the insulating adhesive 10. The insulating adhesive 10 may be a thermosetting resin composition containing (a) an epoxy resin and (b) a latent curing agent.

The epoxy resin may be a single epoxy compound with two or more glycidyl groups in the molecule, or it may be a combination of two or more different ones. Specific epoxy resins include bisphenol-type epoxy resins derived from epichlorohydrin and bisphenols such as bisphenol A, bisphenol F and bisphenol AD, epoxy-novolac resins derived from epichlorohydrin and phenol-novolac or cresol-novolac resins, naphthalene-based epoxy resins with a naphthalene ring-containing skeleton, or glycidylamine-type epoxy resins, glycidyl ether-type epoxy resins, biphenyl-type epoxy resins, alicyclic epoxy resins and the like. These epoxy resins are preferably high purity products with the impurity ion (Na⁺, Cl⁻, etc.) and hydrolyzable chlorine concentration reduced to below 300 ppm, in order to prevent electron migration.

As latent curing agents there may be mentioned imidazole-based, hydrazide-based, boron trifluoride-amine complex, sulfonium salt, amineimide, polyamine salt and dicyandiamide curing agents. They may be used alone or in mixtures of two or more. They may also be used in combination with triggers, inhibitors and the like. From the viewpoint of extending the usable life, these curing agents are preferably used in a microencapsulated form by coating with a polyurethane-based or polyester-based macromolecular compound.

The insulating adhesive 10 may also be a thermosetting resin composition comprising (c) a curing agent that generates free radicals by heat or light, and (d) a radical-polymerizing substance.

The curing agent that generates free radicals by heat or light (hereinafter also referred to as "free radical generator") may be a peroxide compound, azo-based compound or the like. The free radical generator may be appropriately selected according to the target connection temperature, connection time and pot life, but from the viewpoint of high reactivity and pot life there are preferred organic peroxides with a 10-hour half-life temperature of 40°C or higher and a 1-minute half-life temperature of no higher than 180°C. The free radical generator content in this case is preferably about 0.05-10 wt% and more preferably 0.1-5 wt% with respect to the insulating adhesive.

The curing agent that generates free radicals by heat or light may be selected, specifically, from among diacyl peroxides, peroxy dicarbonates, peroxy esters, peroxy ketals, dialkyl peroxides and hydroperoxides. In order to minimize corrosion of the connecting terminals of the circuit members it is preferred to select a peroxy ester, dialkyl peroxide or hydroperoxide, and more preferably to select a peroxy ester which exhibits high reactivity.

As examples of diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As examples of peroxy dicarbonates there may be mentioned din-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy) dicarbonate, dimethoxybutylperoxy dicarbonate and di(3-methyl-3-methoxybutylperoxy)dicarbonate.

As examples of peroxy esters there may be mentioned cumylperoxy neodecanoate, 1,1,3,3-tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy-2-ethyl hexanonate, 2,5-dimethyl-2,5-bis(2-ethylhexanoylperoxy)hexane, 1-cyclohexyl-1-methylethylperoxy-2-ethyl hexanonate, t-hexylperoxy-2-ethyl hexanonate, t-butylperoxy-2-ethyl hexanonate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethyl-2,5-bis(m-toluoylperoxy)hexane, t-butylperoxyisopropyl monocarbonate, t-butylperoxy-2-ethylhexyl monocarbonate, t-hexylperoxybenzoate and t-butylperoxy acetate.

As examples of peroxy ketals there may be mentioned 1,1-bis(t-hexylperoxy)-3,5,5-trimethylcyclohexane, 1,1-bis(t-hexylperoxy)cyclohexane, 1,1-bis(t-butylperoxy)-3,5,5-trimethylcyclohexane, 1,1-(t-butylperoxy)cyclododecane and 2,2-bis(t-butylperoxy)decane.

As examples of dialkyl peroxides there may be mentioned α,α'-bis(t-butylperoxy)diisopropylbenzene, dicumyl peroxide, 2,5-dimethyl-2,5-di(t-butylperoxy)hexane and t-butylcumyl peroxide.

As examples of hydroperoxides there may be mentioned diisopropylbenzene hydroperoxide and cumene hydroperoxide.

Any of these free radical generators may be used alone or in mixtures of two or more. They may also be used in combination with triggers, inhibitors and the like.

The radical-polymerizing substance is a substance having functional groups that polymerize by radicals. The radical-polymerizing substance is selected from among acrylate, methacrylate and maleimide compounds, for example.

As examples of acrylates or methacrylates there may be mentioned urethane acrylate, methyl acrylate, ethyl acrylate, isopropyl acrylate, isobutyl acrylate, ethyleneglycol diacrylate, diethyleneglycol diacrylate, triethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, bis(acryloxyethyl)isocyanurate, ε-caprolactone-modified tris(acryloxyethyl)isocyanurate and tris(acryloxyethyl)isocyanurate.

Any of these radical-polymerizing substances may be used alone or in combinations of two or more. The insulating adhesive composing the circuit connecting adhesive film more preferably contains at least a radical-polymerizing substance with a 25°C viscosity of 100000-1000000 mPa·s, and even more preferably contains a radical-polymerizing substance with a viscosity (25°C) of 100000-500000 mPa·s. The viscosity of the radical-polymerizing substance may be measured using a commercially available cone-plate (E type) viscometer.

Urethane acrylate or urethane methacrylate is preferred among these radical-polymerizing substances from the viewpoint of adhesion. It is particularly preferred to use in combination a urethane acrylate and/or urethane methacrylate and a radical-polymerizing substance that forms a cured product with a glass transition temperature of 100°C or higher when cured alone with an organic peroxide. This will further improve the post-curing heat resistance. As radical-polymerizing substances that form cured products with glass transition temperatures of 100°C and higher there may be used substances having dicyclopentenyl, tricyclodecanyl and/or triazine rings. Particularly preferred for use are radical-polymerizing substances with tricyclodecanyl and/or triazine ring groups.

If necessary, the insulating adhesive 10 may also contain a polymerization inhibitor such as hydroquinone or a methyl ether hydroquinone.

The insulating adhesive 10 preferably contains a (meth)acrylate with a phosphoric acid ester structure at 0.1-10 parts by weight with respect to 100 parts by weight as the entire radical-polymerizing substance. This will improve the bonding strength on inorganic material surfaces such as metals. The amount of radical-polymerizing substance with a phosphoric acid ester structure is more preferably 0.5-5 parts by weight. The radical-polymerizing substance with a phosphoric acid ester structure is obtained as the reaction product of phosphoric anhydride and 2-hydroxyl (meth)acrylate. Specifically there may be mentioned 2-methacryloyloxyethyl acid phosphate and 2-acryloyloxyethyl acid phosphate. These may be used alone or in combinations of two or more.

Preferred maleimide compounds are those with at least two maleimide groups in the molecule. As examples of preferred maleimide compounds there may be mentioned 1-methyl-2,4-bismaleimidebenzene, N,N'-m-phenylenebismaleimide, N,N'-P-phenylenebismaleimide, N,N'-m-toluilenebismaleimide, N,N'-4,4-biphenylenebismaleimide, N,N'-4,4-(3,3'-dimethyl-biphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-4,4-diphenyl etherbismaleimide, N,N'-3,3'-diphenylsulfonebismaleimide, 2,2-bis[4-(4-maleimidephenoxy)phenyl]propane, 2,2-bis [3-s-butyl-4,8-(4-maleimidephenoxy)phenyl]propane, 1,1-bis[4-(4-maleimidephenoxy)phenyl]decane, 4,4'-cyclohexylidene-bis[1-(4-maleimidephenoxy)-2-cyclohexyl]benxene and 2,2-bis[4-(4-maleimidephenoxy)phenyl]hexafluoropropane. Any of these may be used alone or in mixtures of two or more. Alternatively, a maleimide compound may be used in combination with an allyl compound such as allylphenol, allylphenyl ether or allyl benzoate.

The circuit connecting adhesive film 1 has excellent manageability since it is in the form of a film. The insulating adhesive 10 may also contain a polymer component that imparts film formability Examples of such polymer components include polystyrenes, polyethylenes, polyvinyl butyrals, polyvinyl formals, polyimides, polyamides, polyesters, polyvinyl chlorides, polyphenylene oxides, urea resins, melamine resins, phenol resins, xylene resins, epoxy resins, polyisocyanate resins, phenoxy resins, polyimide resins and polyester-urethane resins. Of these, resins with functional groups such as hydroxyl are preferred since they can improve the adhesion. Such polymer components that have been modified with radical-polymerizing functional groups may also be used. The weight-average molecular weight of such a polymer component is preferably at least 10000. A weight-average molecular weight of 1000000 or greater will lower the mixing property, and therefore it is preferably less than 1000000.

The insulating adhesive 10 may contain a filler, softening agent, accelerator, antioxidant, coloring agent, flame retardant, thixotropic agent, coupling agent, diisocyanate compound or the like.

As diisocyanates there may be mentioned those obtained by reaction between diamines and phosgene. As specific examples of diisocyanates there may be mentioned diphenylmethanediisocyanates and toluilenediisocyanates wherein the amino groups of the diamines mentioned below have been converted to isocyanate groups.

An aromatic amine may be used as the diamine. As specific examples of aromatic amines there may be mentioned aromatic diamines such as 4,4'- (or 3,4'-, 3,3'- or 2,4'-)diaminodiphenyl ether, 4,4'- (or 3,3'-)diaminodiphenylsulfone, 4,4'- (or 3,3'-)diaminodiphenylsulfide, 4,4'-benzophenonediamine, 3,3'-benzophenonediamine, 4,4'-di(4-aminophenoxy)phenylsulfone, 4,4'-di(3-aminophenoxy)phenylsulfone, 4,4'-bis(4-aminophenoxy)biphenyl, 1,4-bis(4-aminophenoxy)benzene, 1,3-bis(4-aminophenoxy)benzene, 2,2-bis{4-(4-aminophenoxy)phenyl}propane, 3,3', 5,5'-tetramethyl-4,4'-diaminodiphenylmethane, 4,4'-di(3-aminophenoxy)phenylsulfone, 2,2'-bis(4-aminophenyl)propane, 2,2'-trifluoromethyl-4,4'-diaminobiphenyl, 2,2', 6,6'-tetramethyl-4,4'-diaminobiphenyl, 2,2', 6,6'-tetratrifluoromethyl-4,4'-diaminobiphenyl, bis{(4-aminophenyl)-2-propyl}1,4-benzene, 9,9-bis(4-aminophenyl)fluorene and 9,9-bis(4-aminophenoxyphenyl)fluorene; 2,6-diaminopyridine, 2,4-diaminopyridine, bis(4-aminophenyl-2-propyl)-1,4-benzene, diaminopolysiloxane compound, 2-nitro-1,4-diaminobenzene, 3,3'-dinitro-4,4'-diaminobiphenyl, 3,3'-dimethoxy-4,4'-diaminobiphenyl, 3,3'-dihydroxy-4,4'-diaminobiphenyl, 2,4-diaminophenol and o-tolidinesulfone, 1,3-diaminobenzene, 1,4-diaminobenzene, 2,4-diaminotoluene, 3,3'-dimethyl-4,4'-diaminobiphenyl, 2,2-bis(trifluoro)-methylbenzidine, 2,2-bis-(4-aminophenyl)propane, 1, 1, 1, 3, 3,3-hexafluoro-2-bis-(4-aminophenyl)propane, 4,4'-diaminodiphenylmethane, 1,5-diaminonaphthalene and 9, 10-bis(4-aminophenyl)anthracene.

As tetracarboxylic acids for reaction with diamines, there may be used ones having two pairs of two adjacent carboxyl groups. As specific examples of tetracarboxylic acids there may be mentioned pyromellitic dianhydride (1,2,3,4-benzenetetracarboxylic dianhydride), 3,4,3',4'-biphenyltetracarboxylic dianhydride, 3,4,3',4'-benzophenonetetracarboxylic dianhydride, 2,3,2',3'-benzophenonetetracarboxylic dianhydride, 2,3,3',4'-biphenyltetracarboxylic dianhydride, 2,2-bis(3,4-dicarboxyphenyl)propane dianhydride, 2,2-bis(2,3-dicarboxyphenyl)propane dianhydride, bis(3,4-dicarboxyphenyl)ether dianhydride, bis(2,3-dicarboxyphenyl)ether dianhydride, bis(3,4-dicarboxyphenyl)sulfone dianhydride, bis(2,3-dicarboxyphenyl)sulfone dianhydride, 4,4'-{2,2,2-trifluoro-1-(trifluoromethyl)ethylidene}bis(1,2-benzenedicarboxylic anhydride), 9,9-bis{4-(3,4-dicarboxyphenoxy)phenyl}fluorene dianhydride, 1,2,5,6-naphthalenetetracarboxylic dianhydride, 2,3,6,7-naphthalenetetracarboxylic dianhydride, 1,4,5,8-naphthalenetetracarboxylic dianhydride, 3,4,9,10-perylenetetracarboxylic dianhydride, 2,3,5,6-pyridinetetracarboxylic dianhydride and bicyclo(2,2,2)-oct-7-ene-2,3,5,6-tetracarboxylic dianhydride.

Preferred coupling agents, from the viewpoint of adhesion, are compounds containing one or more groups selected from among vinyl, acrylic, amino, epoxy and isocyanate groups.

As conductive particles 12 there may be mentioned metallic particles containing at least one metal selected from among Au, Ag, Ni, Cu and solder, and carbon particles. There may also be used conductive particles comprising insulating particles used as nuclei and one or more layers covering them, wherein the outermost layer of the layers covering the insulating particles is a conductive layer. In this case, the metal forming the outermost layer is preferably an Au, Ag or platinum precious metal rather than a transition metal such as Ni or Cu in order to obtain a sufficient pot life, and Au is more preferred.

The conductive particles 12 may also have the surface of a transition metal such as Ni covered with a precious metal such as Au. The conductive particles 12 may consist of insulating particles of non-conductive glass, ceramic or plastic covered with a conductive substance such as a metal. It is preferred for the conductive particles 12 to comprise insulating particles covered with a covering layer of a conductive substance with the outermost layer formed of a precious metal and the insulating particle nuclei formed of plastic, or for the conductive particles to be heat-fusible metallic particles, in order to further facilitate deformation by heat and pressure and to increase the contact area with the electrodes during connection for improved reliability

The thickness of a precious metal covering layer is preferably at least 100 Å to obtain satisfactory resistance. However, when a precious metal covering layer is formed on a transition metal such as Ni, oxidation-reduction action produced by loss of the precious metal covering layer or loss of the precious metal covering layer caused by mixing and dispersion of the conductive particles, results in generation of free radicals and reduces the pot life, and therefore the thickness of the covering layer when using a radical polymerizing adhesive component is preferably at least 300 Å.

The amount of conductive particles 12 is adjusted in a range of 0.1-30 parts by volume with respect to 100 parts by volume of the insulating adhesive 10, according to the purpose of use. From the viewpoint of more thoroughly preventing shorting between adjacent circuits by excess conductive particles, the content is more preferably 0.1-10 parts by volume.

The particle size of the conductive particles 12 is preferably smaller than the heights of the circuit electrodes to be connected. This can further reduce shorting between adjacent electrodes. Specifically, the particle size of the conductive particles is preferably 1-20 µm, more preferably 1.5-15 µm and even more preferably 2-10 µm. The 10% compression modulus (K value) of the conductive particles 12 is preferably 100-1000 kgf/mm².

The particulate non-conductive phase 14 comprises a polyester-based elastomer and/or polyamide-based elastomer. The non-conductive particles containing the elastomer may be dispersed in the insulating adhesive as a non-conductive phase 14, or the islands of a phase separation structure with the sea-island structure may be formed as the non-conductive phase 14 in the insulating adhesive 10.

The melting point of the non-conductive phase 14 is preferably 100-250°C. When the circuit connecting adhesive film 1 has been heated and pressed for circuit connection, and specifically when it has been pressed while heating at 100-250°C, for example, the non-conductive phase 14 is preferably melted and dissolved in the insulating adhesive 10. This will further improve the visibility of impressions by the conductive particles 12.

For the same reason, the particle size of the non-conductive phase 14 is preferably 1-10 µm. The circuit connecting adhesive film 1 preferably comprises the non-conductive phase 14 at 1-60 parts by weight with respect to 100 parts by weight of the insulating adhesive.

The circuit connecting adhesive film has the function of melting and flowing during connection to establish connection between the opposing circuit electrodes (connecting terminals), and then curing to maintain the connection. The flow property of the adhesive film is therefore an important factor. Specifically, when a 5 mm × 5 mm adhesive film with a thickness of 35 µm is sandwiched between two 15 mm × 15 mm glass plates with a thickness of 0.7 mm, and heated and pressed at 170°C, 2 MPa for 10 seconds, the value of the flow property (B)/(A), where (A) is the initial area and (B) is the area after heating and pressing, is preferably 1.3-3.0 and more preferably 1.5-2.5. If the value is less than 1.3 the flow property will be insufficient to establish satisfactory connection, while if it is greater than 3.0, air bubbles will tend to be generated and will lower the reliability.

The 40°C elastic modulus after curing of the circuit connecting adhesive film is preferably 100-3000 MPa and more preferably 500-2000 MPa.

The circuit connecting adhesive film of the invention is not limited to the embodiments described above, and it may incorporate appropriate modifications that still fall within the scope of the gist of the invention. For example, the circuit connecting adhesive film may be composed of a plurality of layers with different compositions. Specifically, for example, the circuit connecting adhesive film may comprise a reactive resin-containing layer and a latent curing agent-containing layer, or it may comprise a layer containing a free radical-generating curing agent and a layer containing conductive particles. This will allow increased high definition while also obtaining an effect of improved pot life. When the circuit connecting adhesive film has a plurality of layers, the non-conductive phase may be present in all of the layers or only one of the layers. However, the non-conductive phase is preferably present with the conductive particles in the uppermost surface layer on the side in contact with the glass panel. The circuit connecting adhesive film will usually be protected on one or both sides by lamination with a resin film such as a PET film having a releasable surface.

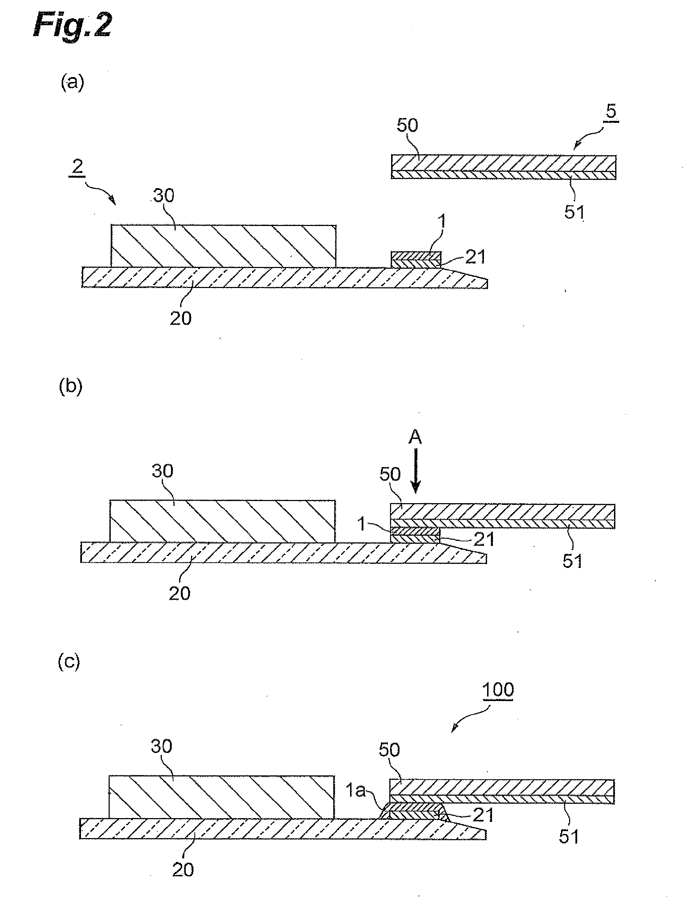

Fig. 2 is a cross-sectional view showing an embodiment of a method for producing a circuit connecting structure. In the method shown in Fig. 2, a LCD panel 2 as the first circuit member with a connecting terminal 21 (first connecting terminal) and a COF (chip-on-film) 5 as the second circuit member with a connecting terminal 51 (second connecting terminal) are connected. The LCD panel 2 comprises a glass panel 20 and a connecting terminal 21 and liquid crystal display 30 formed on the glass panel 20. The COF 5 comprises a resin board 50 and a connecting terminal 51 formed on the resin board 50.

The method illustrated in Fig. 2 comprises a step of attaching the circuit connecting adhesive film 1 to the connecting terminal 21 (Fig. 2(a)) and a step of positioning the COF 5 so that the connecting terminal 51 is laid facing the connecting terminal 21 sandwiching the circuit connecting adhesive film 1 between them, and heating them in this state while pressing in the direction of arrow A (the direction vertical to the main side of the circuit member) to cause the circuit connecting adhesive film 1 to flow, and then curing it to form an adhesive layer 1a lying between and bonding the LCD panel 2 and COF 5 (Fig. 2(b), (c)). This yields a circuit connecting structure 100 in which the connecting terminal 21 of the LCD panel 2 and the connecting terminal 51 of the COF 5 are electrically connected.

The heating and pressing for connection are carried out so that impressions are formed on the surface when the conductive particles 12 are pressed on the connecting terminal 21. After connection, the condition of the impressions at the joint is observed from the glass panel 20 side in order to confirm the connected state of the circuit connecting structure 100. When a conventional circuit connecting adhesive film containing added non-conductive particles is used, the impressions of the conductive particles blend with the impressions of the non-conductive particles themselves, and the distribution of the impressions of the conductive particles themselves is also non-uniform. Furthermore, voids have often formed in the adhesive layer 1a due to the non-conductive particles. In contrast, using the circuit connecting adhesive film of this embodiment can provide satisfactory visibility of impressions on electrode surfaces by conductive particles, while also preventing generation of voids after connection.

The circuit connecting adhesive film of this embodiment is not limited to connection of an LCD panel and COF as described above, but is also useful as an anisotropic conductive film for bonding between circuit members with connecting terminals. As examples of circuit members to be bonded there may be mentioned chip parts such as semiconductor chips, resistor chips and condenser chips, and circuit boards such as printed boards. The circuit connecting adhesive film of this embodiment can also be suitably used for bonding between semiconductor chips (IC chips) and circuit boards or bonding between electrical circuit board phases. Connecting terminals having these circuit members are electrically connected by direct contact or via the conductive particles in the circuit connecting adhesive film.

Preferably, at least one of the connecting terminals of the circuit members to be connected is one whose surface is formed from a metal selected from among gold, silver, tin and platinum metals.

### [Examples]

The present invention will now be explained in greater detail by examples. However, the invention is not limited to these examples.

### Example 1

After combining 20 parts by weight of the radical-polymerizing substance urethane acrylate (trade name: UA-5500T, product of Shin-Nakamura Chemical Co., Ltd.), 20 parts by weight of bis(acryloxyethyl) isocyanurate (trade name: M-215, product of ToaGosei Co., Ltd.), 10 parts by weight of dimethyloltricyclodecane diacrylate (trade name: DCP-A, product of Kyoeisha Chemical Co., Ltd.), 1 part by weight of 2-methacryloyloxyethyl acid phosphate (trade name: P-2M, product of Kyoeisha Chemical Co., Ltd.), 3 parts by weight of benzoyl peroxide (trade name: HYPER BMT-K, product of NOF Corp.) as the free radical generator and 50 parts by weight of a 40 wt% solution of a polyester-urethane resin (trade name: UR8240, product of Toyobo, Ltd.) in a toluene/methyl ethyl ketone = 50/50 mixed solvent, the mixture was stirred to obtain an insulating adhesive solution.

To this solution there were added and dispersed 3 vol% of conductive particles with respect to the insulating adhesive, and then 5 parts by weight of non-conductive particles were dispersed with respect to 100 parts by weight of the insulating adhesive. The conductive particles used were covered particles comprising polystyrene particles as the nuclei, a 0.2 µm-thick nickel layer formed on the polystyrene particles, and a 0.04 µm-thick gold layer formed on the outside of the nickel layer. The mean particle size of the conductive particles was 4 µm, and the 10% compression modulus (K value) was 410 Kgf/mm². As non-conductive particles there were used polyester-based elastomer particles (mean particle size: 5 µm, 10% compression modulus (K value): 250 Kgf/mm², melting point: 160°C).

A coating apparatus was used to coat a solution containing the conductive particles and non-conductive particles onto a 50 µm-thick PET film that had been surface-treated on one side, and the coating was dried with hot air at 70°C for 10 minutes to form an adhesive film with a thickness of 18 µm, thus obtaining a tape-like circuit connection material with a PET film and an adhesive film (width: 15 cm, length: 60 m). The obtained circuit-connecting material was cut to a width of 1.2 mm and wound up to 50 m on a plastic reel with an inner diameter of 40 mm and an outer diameter of 48 mm, with the adhesive film side facing the reel surface (thickness: 1.5 mm).

### Examples 2-5

A tape-like circuit-connecting material was fabricated in the same manner as Example 1, except that the types and amounts of non-conductive particles were changed as shown in Table 1. The non-conductive particles used in Example 2 were polyamide-based elastomer particles (mean particle size: 10 µm, 10% compression modulus (K value): 260 Kgf/mm², melting point: 170°C), the non-conductive particles used in Example 3 were polyamide-based elastomer particles (mean particle size: 5 µm, 10% compression modulus (K value): 270 Kgf/mm², melting point: 180°C), the non-conductive particles used in Example 4 were polyamide-based elastomer particles (mean particle size: 3 µm, 10% compression modulus (K value): 280 Kgf/mm², melting point: 200°C), and the non-conductive particles used in Example 5 were polyester-based elastomer particles (mean particle size: 5 µm, 10% compression modulus (K value): 290 Kgf/mm², melting point: 210°C).

### Comparative Examples 1-5

As non-conductive particles there were used polystyrene-divinylbenzene copolymer fine particles (6 µm, 10% compression modulus (K value): 320 Kgf/mm², product name: PB3006), silicone fine particles (2 µm, 10% compression modulus (K value): 35 Kgf/mm², product name: KMP605), methacrylic acid ester copolymer fine particles (5 µm, 10% compression modulus (K value): 330 Kgf/mm², trade name: MX500), nylon fine particles (5 µm, 10% compression modulus (K value): 200 Kgf/mm²) and polyimide fine particles (3 µm, 10% compression modulus (K value): 390 Kgf/mm²). A tape-like circuit-connecting material was fabricated in the same manner as Example 1, except that the amounts of each of the components were changed as shown in Table 2.

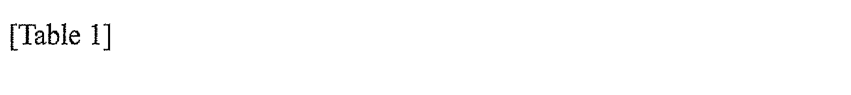

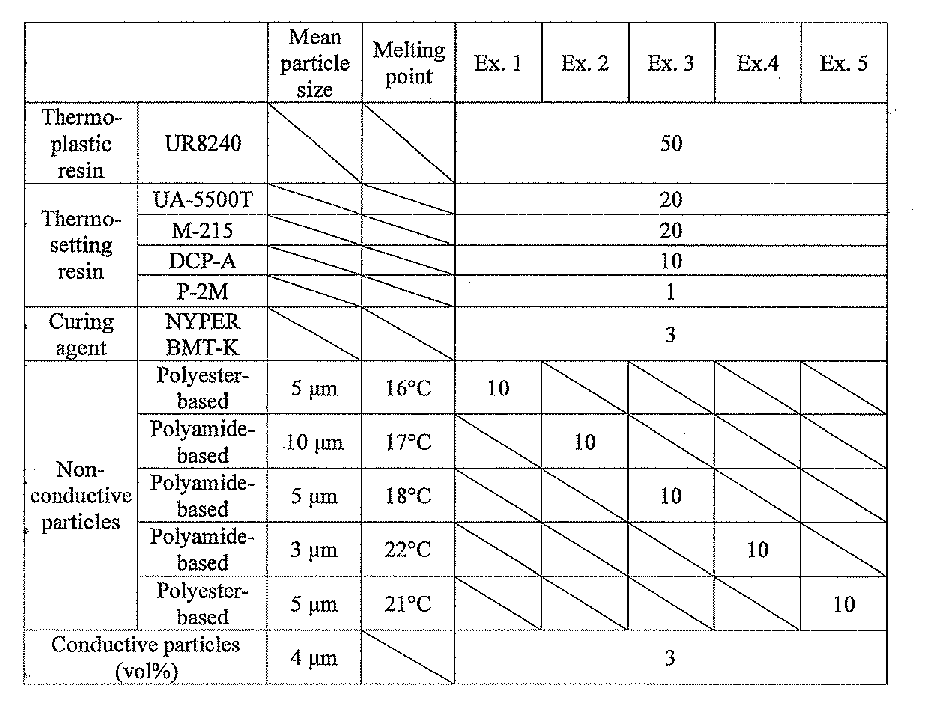

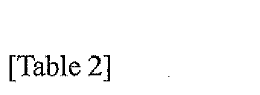

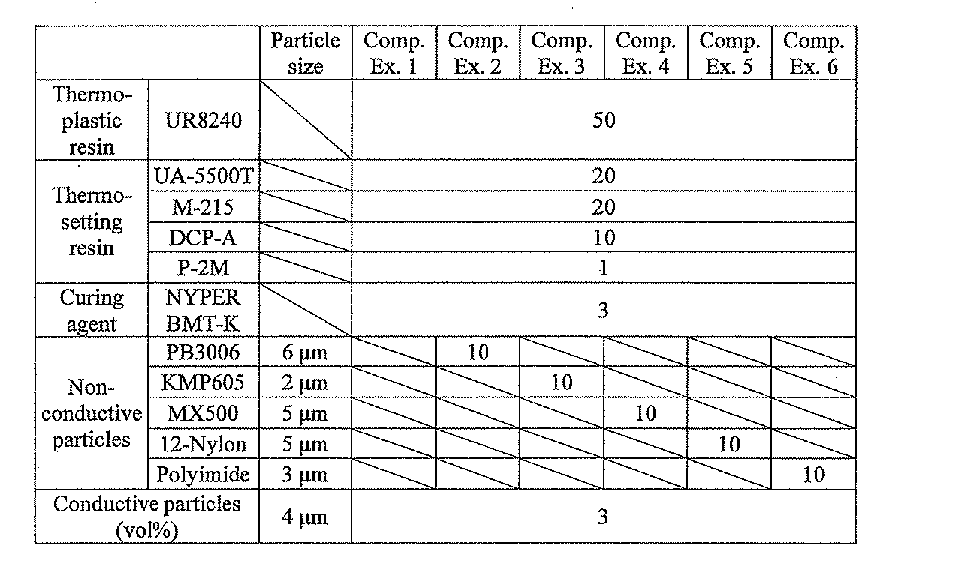

### (Observation of impressions after circuit connection)

The adhesive film side of each circuit-connecting material obtained in the examples and comparative examples (width: 1.2 mm, length: 3 cm) was attached to a glass panel having a 7 µm-thick soda lime glass and an A1 film formed on the main side thereof, and hot pressed at 70°C, 1 MPa for 2 seconds, and then the PET film was released to transfer the adhesive film to the glass panel. Next, a flexible circuit board (FPC) with 600 tin-plated copper circuits at a pitch of 50 µm and with a thickness of 8 µm was placed on the transferred adhesive film and pressed at 24°C, 0.5 MPa for 1 second for temporary attachment. The glass panel on which the FPC had been temporarily attached with the circuit-connecting material was situated on a main contact bonding apparatus and heated and pressed at 180°C, 3 MPa for 6 seconds by heat sealing from the FPC side, to connect the Al film of the glass panel and the plated copper circuit across a width of 1.2 mm in the lengthwise direction of the plated copper circuit. A 200 µm-thick silicone rubber material was used as a cushion material during the heating and pressing.

The state of impressions at the joint was observed from the glass panel by Nomarski differential interference observation using a BH3-MJL liquid crystal panel examining microscope by Olympus Corp. As a result of the observation, a judgment of "good" was assigned when virtually no impressions by non-conductive particles were seen, and a judgment of "poor" was assigned when impressions by non-conductive particles were confirmed. The condition of voids generated at the joint was also observed, and a judgment of "good" was assigned when virtually no generation of voids was seen, while a judgment of "poor" was assigned when significant generation of voids was seen. The evaluation results are shown in Tables 3 and 4.

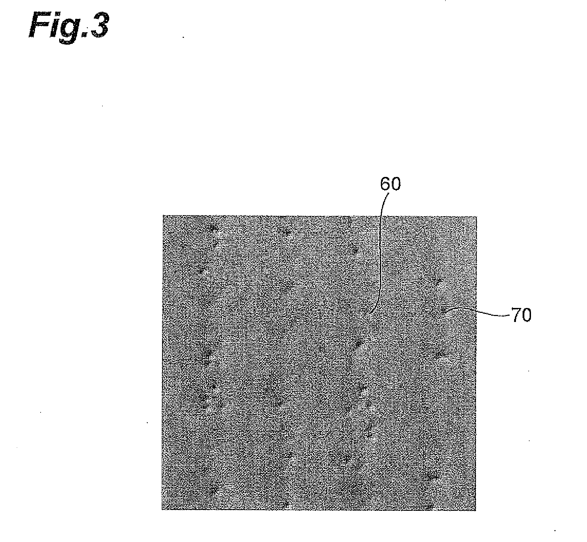

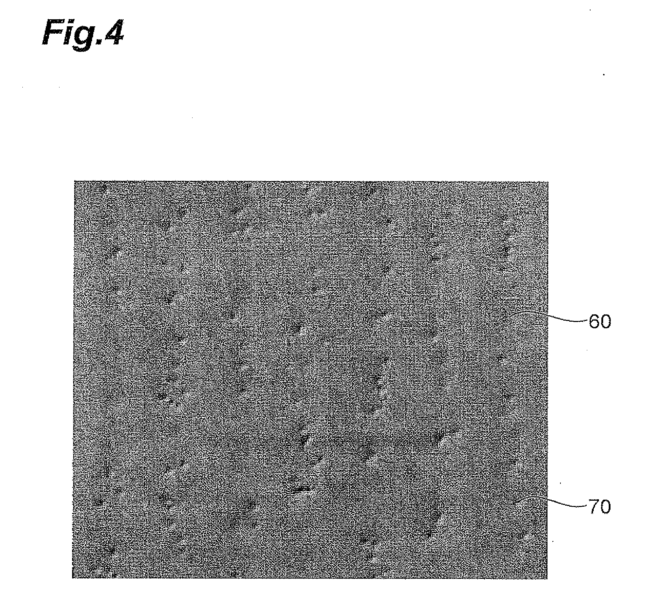

Fig. 3 and Fig. 4 are photomicrographs of the joints of the circuit connecting structures fabricated in Comparative Examples 2 and 3. As seen in Fig. 3, in Comparative Example 2 many impressions 60 due to non-conductive particles were observed separately from the impressions 70 due to the conductive particles. The distribution of impressions 70 was also non-uniform. On the other hand, in Comparative Example 3 which employed relatively soft silicone fine particles as the non-conductive particles, even though the proportion of impressions 70 due to non-conductive particles was lower compared to Comparative Example 2, large impressions 70 due to the silicone fine particles with large particle sizes was produced, as shown in Fig. 4. It is extremely difficult to remove portions with large particle sizes from soft non-conductive particles.

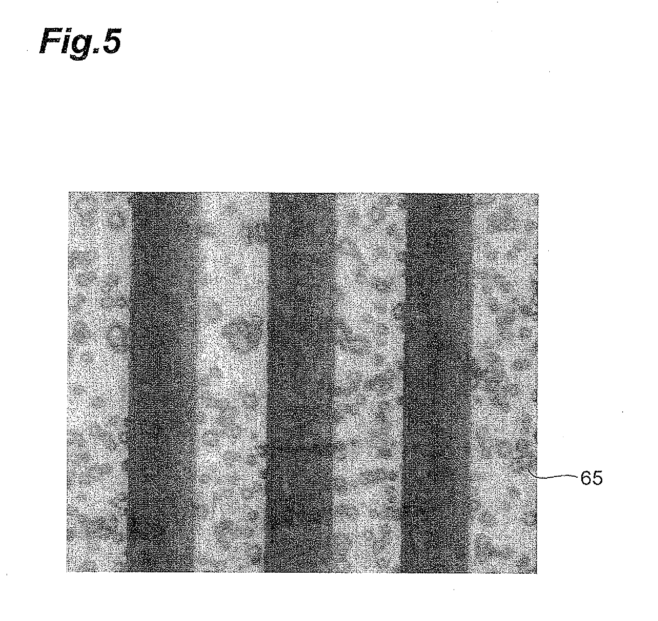

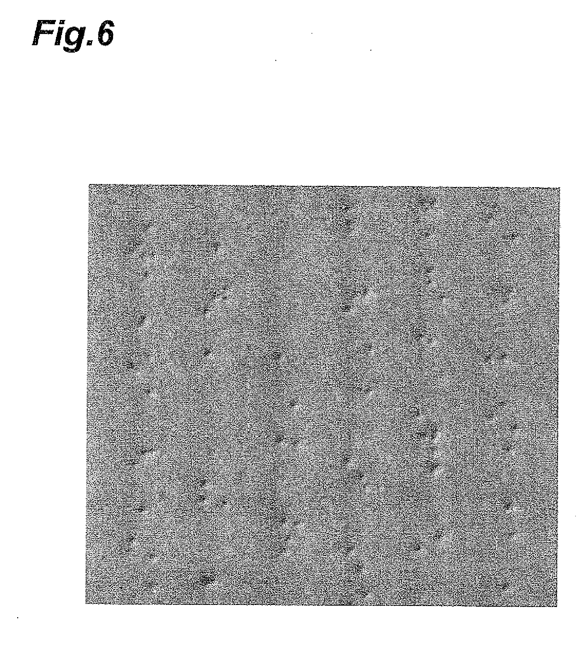

Fig. 5 is a photomicrograph of the joint of the circuit connecting structure fabricated in Comparative Example 5, which employed nylon fine particles. In the case of nylon fine particles, the visibility of the impressions of the conductive particles was relatively satisfactory but many voids 65 were generated by the nylon fine particles, as shown in Fig. 6.

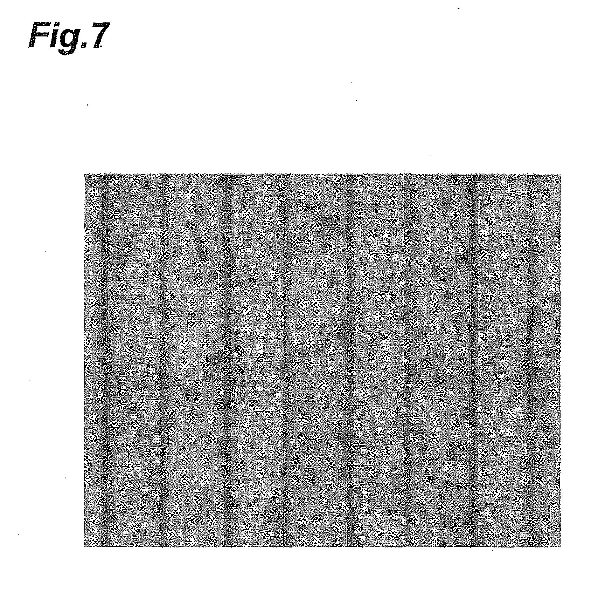

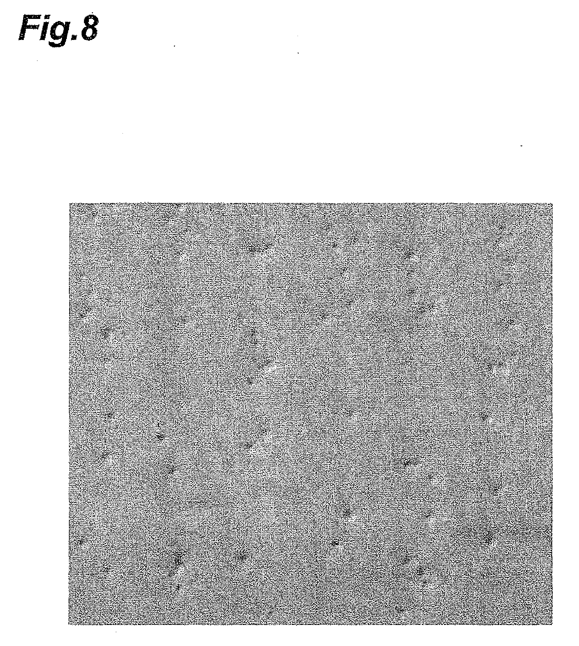

Fig. 6 and Fig. 7 are photomicrographs of the joint of the circuit connecting structure fabricated in Example 1, which employed polyester-based elastomer particles. Fig. 8 is a photomicrograph of the joint of the circuit connecting structure fabricated in Example 3, which employed polyamide-based elastomer particles. In each example, only impressions due to the conductive particles were uniformly observed, and virtually no void generation was seen.

### (Measurement of connection resistance and adhesive force)

The adhesive film side of each circuit-connecting material obtained in the examples and comparative examples (width: 1.2 mm, length: 3 cm) was attached to an ITO-coated glass panel (15 Ω sq.) panel and hot pressed at 70°C, 1 MPa for 2 seconds, and then the PET film was released to transfer the adhesive film to the glass panel. Next, a flexible circuit board (FPC) with 600 tin-plated copper circuits at a pitch of 50 µm and with a thickness of 8 µm was placed on the transferred adhesive film and pressed at 24°C, 0.5 MPa for 1 second for temporary attachment. The ITO-coated glass panel on which the FPC had been temporarily attached with the circuit-connecting material was situated on a main contact bonding apparatus and heated and pressed at 180°C, 3 MPa for 6 seconds by heat sealing from the FPC side, to connect the copper-plated circuit and ITO across a width of 1.2 mm in the lengthwise direction of the plated copper circuit. A 200 µm-thick silicone rubber material was used as a cushion material during the heating and pressing.

After connection, the resistance value between adjacent circuits of the FPC comprising the joint was measured at 40 points using a multimeter (apparatus name: TR6845, product of Advantest Corp.) and the mean value was determined as the connection resistance. The adhesive force was also measured under conditions with 90° peeling and a peel rate of 50 mm/min. The obtained results are shown in Tables 3 and 4.

**[Table 3]**

| | | Ex. 1 | Ex. 2 | Ex. 3 | Ex. 4 | Ex. 5 |
|---|---|---|---|---|---|---|
| Impressions | - | Good | Good | Good | Good | Good |
| Adhesive force | N/m | 1300 | 1205 | 1453 | 1392 | 1255 |
| Connection resistance | Ω | 1.5 | 1.5 | 1.5 | 1.5 | 1.5 |
| Voids | - | Good | Good | Good | Good | Good |

**[Table 4]**

| | | Comp. Ex. 1 | Comp. Ex. 2 | Comp. Ex. 3 | Comp. Ex.4 | Comp. Ex. 5 | Comp. Ex. 6 |
|---|---|---|---|---|---|---|---|
| Impressions | - | Good | Poor | Poor | Poor | Good | Poor |
| Adhesive force | N/m | 1250 | 1225 | 1432 | 1335 | 1295 | 1385 |
| Connection resistance | Ω | 1.5 | 1.5 | 1.5 | 1.5 | 1.5 | 1.5 |
| Voids | - | Good | Good | Good | Good | Poor | Good |

These experimental results confirmed that a circuit-connecting material according to the invention allows easier confirmation of the state of impressions due to conductive particles while also inhibiting generation of voids after connection. In addition, it was confirmed that a circuit-connecting material according to the invention exhibits satisfactory adhesive force and connection resistance.

## Claims

1. A circuit connecting adhesive film comprising an insulating adhesive, conductive particles and a particulate non-conductive phase containing a polyamide-based elastomer and/or a polyester-based elastomer, wherein the conductive particles and non-conductive phase are dispersed in the insulating adhesive.

2. The circuit connecting adhesive film according to claim 1, comprising the non-conductive phase at 1-60 parts by weight with respect to 100 parts by weight of the insulating adhesive.

3. The circuit connecting adhesive film according to claim 1 or 2, wherein the melting point of the non-conductive phase is 100-250°C.

4. The circuit connecting adhesive film according to any one of claims 1 to 3, wherein the non-conductive phase dissolves in the insulating adhesive when the circuit connecting adhesive film is heated and pressed.

5. A circuit connecting structure comprising:
a first circuit member with a first connecting terminal;
a second circuit member with a second connecting terminal that is laid facing and electrically connected to the first connecting terminal; and
an adhesive layer situated between the first circuit member and second circuit member and bonding them,
wherein the adhesive layer is a layer formed by heating and pressing the circuit connecting adhesive film according to any one of claims 1 to 4 situated between the first circuit member and the second circuit member.
